(19) **Europäisches Patentamt European Patent Office Office européen des brevets**

(11) **EP 4 063 875 B1**

(12) **EUROPEAN PATENT SPECIFICATION**

(45) Date of publication and mention of the grant of the patent:
**03.09.2025   Bulletin 2025/36**

(21) Application number: **19953096.5**

(22) Date of filing: **18.11.2019**

(51) International Patent Classification (IPC):
**G01R 31/00** *(2006.01)*      **G01R 31/40** *(2020.01)*

(52) Cooperative Patent Classification (CPC):
**G01R 31/008; G01R 31/40**

(86) International application number:
**PCT/CN2019/119160**

(87) International publication number:
**WO 2021/097604 (27.05.2021 Gazette 2021/21)**

(54) **MULTI-INFORMATION FUSION-BASED FAULT EARLY WARNING METHOD AND DEVICE FOR CONVERTER**

AUF DER ZUSAMMENFÜHRUNG MEHRERER INFORMATIONEN BASIERENDES VERFAHREN UND GERÄT ZUR FRÜHWARNUNG VOR FEHLERN FÜR EINEN UMRICHTER

PROCÉDÉ ET DISPOSITIF D'AVERTISSEMENT PRÉCOCE D'UNE DÉFAILLANCE FAISANT APPEL LA FUSION DE MULTIPLES INFORMATIONS ET DESTINÉS À UN CONVERTISSEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**28.09.2022   Bulletin 2022/39**

(73) Proprietor: **Zhuzhou CRRC Times Electric Co., Ltd.**
**Zhuzhou, Hunan 412001 (CN)**

(72) Inventors:
 • **XU, Shaolong**
   **Zhuzhou, Hunan 412001 (CN)**
 • **LIU, Yongjiang**
   **Zhuzhou, Hunan 412001 (CN)**
 • **HE, Guanqiang**
   **Zhuzhou, Hunan 412001 (CN)**
 • **LI, Hua**
   **Zhuzhou, Hunan 412001 (CN)**
 • **CHEN, Jun**
   **Zhuzhou, Hunan 412001 (CN)**
 • **WANG, Liang**
   **Zhuzhou, Hunan 412001 (CN)**
 • **ZANG, Xiaobin**
   **Zhuzhou, Hunan 412001 (CN)**
 • **WAN, Weiwei**
   **Zhuzhou, Hunan 412001 (CN)**
 • **PENG, Xuanlin**
   **Zhuzhou, Hunan 412001 (CN)**
 • **LI, Yuyin**
   **Zhuzhou, Hunan 412001 (CN)**
 • **WU, Shuzhou**
   **Zhuzhou, Hunan 412001 (CN)**
 • **ZENG, Xianghao**
   **Zhuzhou, Hunan 412001 (CN)**

(74) Representative: **Peters, Sebastian Martinus**
**Octrooibureau Vriesendorp & Gaade B.V.**
**Koninginnegracht 19**
**2514 AB Den Haag (NL)**

(56) References cited:
   CN-A- 103 439 658      CN-A- 104 502 758
   CN-A- 105 044 497      CN-A- 105 044 497
   CN-A- 109 116 150      CN-A- 109 754 110
   CN-A- 109 917 200      CN-A- 109 917 200
   CN-A- 109 973 331      US-A1- 2018 119 677

**(Cont. next page)**

- **KIRANYAZ SERKAN ET AL: "Real-Time Fault Detection and Identification for MMC Using 1-D Convolutional Neural Networks", IEEE TRANSACTIONS ON INDUSTRIAL ELECTRONICS, IEEE SERVICE CENTER, PISCATAWAY, NJ, USA, vol. 66, no. 11, 1 November 2019 (2019-11-01), pages 8760 - 8771, XP011733215, ISSN: 0278-0046, [retrieved on 20190701], DOI: 10.1109/TIE.2018.2833045**

## Description

## Technical Field

The present invention relates to a fault early warning technology for a converter, in particular to a fault early warning method for a converter based on multi-information fusion, a fault early warning device for a converter based on multi-information fusion, and a computer-readable medium.

## Background

Safety is an eternal theme of rail transit. With the increase of rail transit operation and construction mileage, as well as the increasing complexity of rail transit vehicle structure, the guarantee of rail transit safety and reliability is facing severe challenges. As the core component of train power traction system, the operation safety and reliability of the traction converter are directly related to traffic safety. Abnormal vehicle parking caused by traction converter failure will not only cause vehicle delay and scheduling confusion, but also cause panic among passengers, resulting in serious economic losses and adverse social impact. Therefore, the condition monitoring, fault early warning and health management for the traction converter can greatly improve the service life thereof, ensure the safe and reliable operation of the converter, and avoid safety accidents caused by fault failure and economic losses caused by vehicle delay, thereby having great engineering significance and economic value.

At present, the fault monitoring of traction converter in the field of rail transit is still in a fault alarm stage, and often needs to check and repair the fault after occurring. This fault alarm mode has high operation and maintenance cost and low efficiency, which is very unfavorable to the safe operation of vehicles.

In order to overcome the above defects existing in the prior art and meet the requirements for safety and reliability of products in the field of rail transit, there is an urgent need in the art for an efficient fault early warning technology of converter, for real-time monitoring of the operation state of traction converter, early warning and accurate positioning of the fault of traction converter, and predicting the service life of traction converter, so as to ensure the safe operation of the vehicle.

It is noted that CN109116150 discloses a power electronic converter fault diagnosis method based on a cerebellar model neural network (CMNN). Data acquisition and noise reduction processing are carried out to obtain a sample with fault information. Fault features are extracted by using methods like time-domain and frequency-domain analysis and then a data sample library is established. A CMNN fault classifier is constructed by offline training carried out based on a Back-Propagation algorithm and then various faults included by the training sample and specific fault locations are classified accurately. The optimal parameters of the fault classifier are extracted and the extracted optimal parameter is directly assigned to a classifier network to carry out classifier testing work. The classifier network with the optimal parameters is implanted into a DSP and fault diagnosis and positioning of the actual circuit are carried out to realized quick self-test of the converter circuit. Accordingly, the healthy state of the converter can be determined.

## Summary

A brief overview of one or more aspects is provided below to provide a basic understanding of these aspects. The summary is not an extensive overview of all of the aspects that are contemplated, and is not intended to identify key or decisive elements in all aspects. The sole purpose of the summary is to present some concepts of one or more aspects in a simplified form as a prelude to the more detailed description that is presented later.

In order to overcome the above defects existing in the prior art and meet the safety and reliability requirements of products in the field of rail transit, the present invention provides a fault early warning method for a converter based on multi-information fusion, a fault early warning device for a converter based on multi-information fusion, and a computer-readable medium for real-time monitoring the operation state of traction converter, as well as early warning and accurate positioning of the fault of traction converter, so as to ensure the safe operation of the vehicle.

The fault early warning method for the converter based on multi-information fusion provided by the present invention comprises: establishing a performance parameter database of the converter, wherein the performance parameter database comprises a performance parameter set of a plurality of functional components of the converter collected when at least one fault occurs; performing feature extraction on the performance parameter set of the performance parameter database to obtain a fault feature parameter database, wherein the fault feature parameter database comprises at least one fault and at least one fault feature parameter group corresponding to each of the fault, and each of the fault feature parameter group comprises a plurality of fault feature parameters, related to a plurality of functional components of the converter; and performing neural network modeling, based on at least one fault and at least one fault feature parameter group corresponding to each of the fault in the fault feature parameter database, to obtain a fault early warning model representing a mapping relationship between the fault and the fault feature parameters.

The fault early warning method for the converter based on multi-information fusion provided by the present invention also comprises: calibrating the fault feature parameters in the fault feature parameter database, based on a fault feature threshold corresponding to a fault degree of each fault, to determine the fault degree of the fault corresponding to each of the fault feature parameter group. The step of performing neural network modeling based on at least one fault and at least one fault feature parameter group corresponding to each of the fault in the fault feature parameter database comprises: performing neural network modeling based on a fault state of the at least one fault and the at least one fault feature parameter group corresponding to each of the fault state in the fault feature parameter database, wherein the fault state comprises a fault type and the fault degree corresponding to each of the fault type.

Alternatively, in the fault early warning method for the converter based on multi-information fusion provided by the present invention, the step of performing neural network modeling comprises performing modeling by using a BP neural network model, the BP neural network model comprises an input layer, a hidden layer and an output layer, the input layer comprises input nodes related to a plurality of fault features corresponding to the plurality of fault feature parameters in the fault feature parameter group, and the output layer comprises output nodes of the at least one fault state.

Alternatively, in the fault early warning method for the converter based on multi-information fusion provided by the present invention, an output of each hidden node in the hidden layer is $y_j = f\left(\sum_i w_{ji} x_i - \theta_j\right)$,

wherein $x_i$ is an input of the input node of the input layer, $w_{ji}$ and $\theta_j$ are respectively a connection weight and a threshold between each hidden node and each input node, i is an index of the input node, and $j$ is an index of the hidden node,

an output of each output node in the output layer is

$O_k = f\left(\sum_j w_{kj} y_j - \theta_k\right)$ , wherein $w_{kj}$ and $\theta_k$ are

respectively a connection weight and a threshold between each output node and each hidden node, and $k$ is an index of the output node.

Alternatively, in the fault early warning method for the converter based on multi-information fusion provided by the present invention, activation function of the BP neural network is a sigmoid function.

Alternatively, in the fault early warning method for the converter based on multi-information fusion provided by the present invention, an error between the output value $O_k$ and an expected output value $t_k$ of the

output node of the output layer is $E = \frac{1}{2}\sum_k (t_k - O_k)$ ,

an weight correction function in a reverse transfer is

$\Delta w_{kj} = -\eta \frac{\partial E}{\partial w_{kj}}$ , $\Delta w_{ji} = -\eta \frac{\partial E}{\partial w_{ji}}$ , and a    threshold    correction    function    is

$\Delta \theta_k = -\eta \frac{\partial E}{\partial \theta_k}, \Delta \theta_j = -\eta \frac{\partial E}{\partial \theta_j}$ , wherein $\eta$ is

between 0.01 ~ 0.8.

Alternatively, in the fault early warning method for the converter based on multi-information fusion provided by the present invention, the expected output value comprises a fault number indicating the fault state.

Alternatively, in the fault early warning method for the converter based on multi-information fusion provided by the present invention, type of the fault comprises one or more of the following: bearing inner ring fault, bearing outer ring fault, bearing ball fault, bearing cage fault, fan dynamic balance failure fault, fan phase loss fault, fan inter turn short circuit fault, fan phase imbalance fault, fan grounding fault, fan surge fault, capacitor overtemperature fault, capacitance loss fault, IGBT overtemperature fault, IGBT overcurrent fault, filter blockage fault, water pump fault, heat exchanger fault, water cooling plate fault, transformer overtemperature fault and transformer insulation failure fault.

Alternatively, in the fault early warning method for the converter based on multi-information fusion provided by the present invention, fault feature corresponding to the fault feature parameter comprises one or more of the following: total value feature, spectrum feature and envelope feature about fan vibration, power factor, unbalance coefficient, negative sequence current, zero sequence current, spectrum feature, envelope feature and energy feature about fan current, temperature effective value and temperature change gradient about transformer temperature, current effective value and current time domain feature about module current, harmonic feature of converter intermediate voltage, temperature effective value and temperature change gradient of IGBT temperature, total value feature and spectrum feature of capacitor current, temperature effective value and temperature change gradient of water temperature at inlet and outlet of the converter, effective value of water pressure at the inlet and outlet of the converter, and temperature effective value of air temperature at inlet and outlet of a filter.

Alternatively, the fault early warning method for the converter based on multi-information fusion provided by the present invention also comprises: acquiring measured performance parameters of the plurality of functional components of the converter; calculating the fault feature parameters based on the measured performance parameters; and determining the fault of the converter based on the fault feature parameters and the fault early warning model.

Alternatively, **in the fault early warning method**

for the converter based on multi-information fusion provided by the present invention, the performance parameter set corresponding to each fault is collected under different working conditions of the converter, and the working conditions comprise operating environment and mileage of a locomotive where the converter is located.

According to another aspect of the present invention, a fault early warning device for a converter based on multi-information fusion is also provided herein.

According to another aspect of the present invention, a computer-readable medium is also provided herein.

The computer-readable medium provided by the present invention stores a computer executable instruction. When the computer executable instruction is executed by the processor, any one of the above fault early warning methods for the converter based on multi-information fusion can be implemented.

**Brief Description of the Drawings**

The above features and advantages of the present invention will be better understood after reading the detailed description of the embodiments of the present disclosure in conjunction with the following figures. In the figures, components are not necessarily drawn to scale, and components having similar related features may have the same or similar reference numerals.

Fig. 1 shows a flowchart of the fault early warning method for the converter according to an aspect of the present invention.

Fig. 2 shows a modeling diagram of the fault early warning method for the converter according to an embodiment of the present invention.

Fig. 3 shows a flowchart of the fault early warning method for the converter according to an embodiment of the present invention.

Fig. 4 shows a flowchart of a state evaluation method for the converter according to another aspect of the present invention.

Fig. 5 shows a schematic diagram of a fan condition evaluation model according to an embodiment of the present invention.

Fig. 6 shows a schematic diagram of a power module state evaluation model according to an embodiment of the present invention.

Fig. 7 shows a schematic diagram of a capacitor state evaluation model according to an embodiment of the present invention.

Fig. 8 shows a schematic diagram of a contactor state evaluation model according to an embodiment of the present invention.

Fig. 9 shows a schematic diagram of a heat dissipation system state evaluation model according to an embodiment of the present invention.

Fig. 10 shows a schematic diagram of a transformer state evaluation model according to an embodiment of the present invention.

Fig. 11 shows a schematic diagram of a cobweb evaluation system according to an embodiment of the present invention.

Fig. 12 shows a flowchart of a life predicting method for the converter according to an embodiment of the present invention.

Fig. 13 shows a structural diagram of the fault early warning device for the converter according to another aspect of the present invention.

Fig. 14 shows a structural diagram of a state evaluation device for the converter according to another aspect of the present invention.

Fig. 15 shows an intelligent platform for condition monitoring and fault early warning for the converter according to an aspect of the present invention.

Fig. 16 shows a working state intelligent monitoring and fault early warning software for the converter according to one aspect of the present invention.

Reference signs

| | |
|---|---|
| 101~103 | steps of the fault early warning method for the converter; |
| 301~306 | steps of the fault early warning method for the converter; |
| 401~404 | steps of the state evaluation method for the converter; |
| 131 | memory; |
| 132 | processor; |
| 141 | memory; |
| 142 | processor. |

**Detailed Description of Embodiments**

The embodiments of the present invention are described in the following detailed description. Other advantages and effects of the present invention will be readily apparent to those skilled in the art from this disclosure. Although the description of the present invention will be described in conjunction with the preferred embodiments, this is not a limitation of the present invention. On the contrary, the invention is described in connection with the embodiments so as to cover other alternatives or modifications that are possible in the embodiments of the present invention. In order to provide a thorough understanding of the present invention, many specific details are comprised in the following description. The present invention may also be practiced without these details. In addition, some specific details are omitted in the description in order to avoid confusing or obscuring the present invention.

In order to overcome the above defects existing in the prior art and meet the safety and reliability requirements of products in the field of rail transit, the present invention provides a fault early warning method for a converter based on multi-information fusion, a fault early warning device for a converter based on multi-information fusion, and a computer-readable medium for real-time monitoring the operation state of traction converter, as well as early warning and accurate positioning of the fault of traction converter, so as to ensure the safe operation of the vehicle.

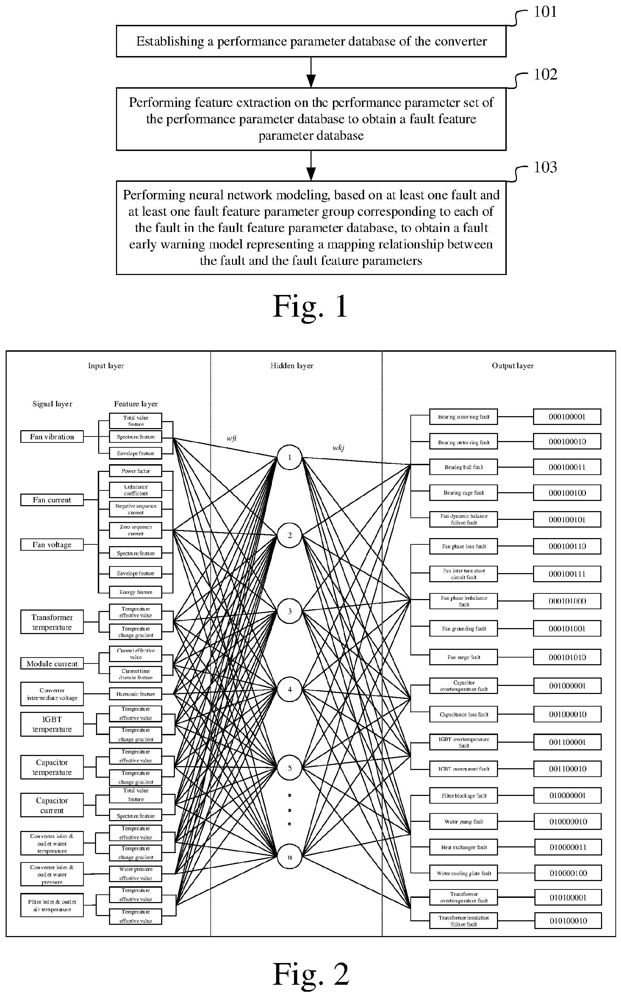

Please refer to Fig. 1, which shows a flowchart of the fault early warning method for the converter according to an aspect of the present invention.

As shown in Fig. 1, the fault early warning method for the converter based on multi-information fusion provided by the invention comprises the following step:

101: establishing a performance parameter database of the converter.

The performance parameter database comprises a performance parameter set of a plurality of functional components of the converter, collected when at least one fault occurs to the converter. In some embodiments, the functional component of the converter comprises all or part of fan, IGBT power module, capacitor, transformer, cabinet lifting lug, heat dissipation system and contactor. In some embodiments, the converter fault comprise one or more of fan fault, IGBT power module fault, capacitor fault, transformer fault, cabinet lifting lug fault, heat dissipation system fault and contactor fault. In some embodiments, the performance parameter set of the functional component comprises a plurality of functional parameters of the functional component. The performance parameters comprise but are not limited to one or more of vibration parameters, current parameters, voltage parameters, temperature parameters and pressure parameters. In some embodiments, the performance parameters can indicate the performance of the corresponding functional components through specific values.

In practice, the parameters in the performance parameter database may come from historical data of an on-board data center, actual operation test data of a line, and bench test data in a maintenance base. In addition, the parameters in the performance parameter database may also be obtained through fault simulation tests, such as artificially manufacturing a fault prototype for signal acquisition under fault, for the on-site fault characteristics of fan, capacitor, contactor and heat dissipation system.

Specifically, in some embodiments, the fan fault may further comprise one or more of bearing inner ring fault, bearing outer ring fault, bearing ball fault, bearing cage fault, fan dynamic balance failure fault, fan phase loss fault, fan inter turn short circuit fault, fan phase imbalance fault, fan grounding fault and fan surge fault. In some embodiments, the IGBT power module faults may further comprise IGBT overtemperature fault and / or IGBT overcurrent fault. In some embodiments, the capacitor fault may further comprise capacitor overtemperature fault and / or capacitance loss fault. In some embodiments, the transformer fault may further comprise transformer overtemperature fault and / or a transformer insulation failure fault. In some embodiments, the heat dissipation system failure may further comprise one or more of filter blockage fault, water pump fault, heat exchanger fault, and water cooling plate fault.

In some embodiments, the fault early warning method for the converter based on multi-information fusion, provided by the present invention, can be implemented on a fault early warning device for the converter based on multi-information fusion. The fault early warning device for the converter can use the sensors arranged in each functional component of the traction converter to collect the performance parameters of each functional component, so as to establish the performance parameter database of the converter according to the performance parameter set of a plurality of functional components. Preferably, the performance parameter set corresponding to each fault may be collected under different working conditions of the converter. The working conditions of the converter comprises operating environment and mileage of the locomotive where the converter is located.

As shown in Fig. 1, the fault early warning method for the converter based on multi-information fusion provided by the invention also comprises the following step:

102: performing feature extraction on the performance parameter set of the performance parameter database to obtain a fault feature parameter database.

The fault feature refers to a feature that have certain directivity to faults of various components of the converter. The fault feature parameter is the specific value of the fault feature, which has a certain correlation with fault state. In some embodiments, the fault feature comprises one or more of total value feature, spectrum feature, and envelope feature about fan vibration, power factor, unbalance coefficient, negative sequence current, zero sequence current, spectrum feature, envelope feature and energy feature about fan current, temperature effective value and temperature change gradient about transformer temperature, current effective value and current time domain feature about module current, harmonic feature of converter intermediate voltage, temperature effective value and temperature change gradient of IGBT temperature, total value feature and spectrum feature of capacitor current, temperature effective value and temperature change gradient of water temperature at inlet and outlet of the converter, effective value of water pressure at the inlet and outlet of the converter, and temperature effective value of air temperature at inlet and outlet of a filter.

The feature extraction can be implemented through a plurality of iterative verification of fault prototype and line operation fault feature data. The feature extraction of the performance parameter set in the performance parameter database can be realized by combining the fault feature of the traction converter, and using mature and reliable feature extraction algorithm in the field, which will not be repeated here.

The above fault feature parameter database comprises at least one fault and at least one fault feature parameter group corresponding to each fault. **Each** group of fault feature parameters comprises a plurality of fault feature parameters of a plurality of functional components of the converter. As shown in Fig. 1, the above fault early warning method for the converter based on multi-information fusion provided by the invention also comprises the following step:

103: performing neural network modeling, based on at least one fault and at least one fault feature parameter group corresponding to each of the fault in the fault feature parameter database, to obtain a fault early warning model representing a mapping relationship between the fault and the fault feature parameters.

The fault early warning device for the converter based on multi-information fusion performs neural network modeling, based on the fault state of at least one fault in the fault feature parameter database and at least one fault feature parameter group corresponding to each fault state. The fault state comprises a fault type and a fault degree corresponding to each fault type. The fault degree of the fault corresponding to each fault feature parameter group is determined by calibrating the fault feature parameters in the fault feature parameter database, by using one or more fault feature thresholds. Each fault feature threshold corresponds to a critical point between two fault degrees of a fault. The fault feature threshold here can be an individual threshold corresponding to only one fault feature or a combined threshold corresponding to a combination of fault features.

In some embodiments, a plurality of fault feature thresholds corresponding to each fault degree of various faults can be determined by fault experiments and / or expert experience of various corresponding faults.

Please refer to Fig. 2, which shows a modeling diagram of the fault early warning method for the converter according to an embodiment of the present invention.

As shown in Fig. 2, in some embodiments, the step of performing neural network modeling comprises performing modeling by using a BP neural network model. The BP neural network model comprises an input layer, a hidden layer and an output layer.

Specifically, the input layer comprises an input node for a plurality of fault features corresponding to the plurality of fault feature parameters in each fault feature parameter group. In some embodiments, the input layer is further divided into a signal layer and a feature layer. The signal layer is original signal measured by the sensor, which comprises fan vibration current and voltage, transformer temperature, module current, converter intermediate voltage, IGBT temperature, capacitor current and temperature, converter inlet and outlet water temperature, converter inlet and outlet water pressure, and filter inlet and outlet air temperature. The feature layer is feature parameter obtained by feature extraction and feature operation of each signal, which comprises total value, spectrum and envelope features of fan vibration, power factor, three-phase unbalance coefficient, negative sequence current, zero sequence current, spectrum feature, envelope feature and energy feature of fan, temperature effective value and temperature change gradient of transformer, effective value and time-domain feature of module current, harmonic feature of intermediate voltage, temperature effective value and temperature change gradient of IGBT, temperature effective value and temperature change gradient of capacitor, total value feature and spectrum feature of capacitor current, effective value and temperature change gradient of inlet and outlet water temperature, effective value of inlet and outlet water pressure, effective value and temperature change gradient of inlet and outlet air temperature. In some embodiments, sample parameter of the input layer can be obtained through fault simulation test and line actual test.

The hidden layer comprises a plurality of hidden nodes. In some embodiments, the number the hidden layer may be one. The number of hidden nodes in the hidden layer can be determined according to the number of input nodes in the input layer and the number of output nodes in the output layer. In some embodiments, the number of the hidden nodes may be a sum of the number of nodes in the input layer and output layer. In some embodiments, the output of each hidden node in the hidden layer is

$$y_j = f\left(\sum_i w_{ji} x_i - \theta_j\right)$$

, wherein

$x_i$ is an input of the input node in the input layer, $w_{ji}$ and $\theta_j$ are respectively a connection weight and a threshold between each hidden node and each input node, $i$ is an index of the input node, and $j$ is an index of the hidden node.

The output layer comprises an output node of at least one fault state. In some embodiments, the output layer may be an output corresponding to a fault diagnosis result. In some embodiments, the output layer comprises one or more of fan bearing inner ring fault, outer ring fault, rolling element fault, cage fault, fan dynamic balance failure fault, fan phase loss fault, inter turn short circuit fault, phase imbalance fault, grounding fault, surge fault, capacitor overtemperature fault, **capacitance** loss fault, IGBT overtemperature fault, overcurrent fault, filter blockage fault, water pump fault, heat exchanger fault, water cooling plate failure, transformer overtemperature fault and insulation failure fault. In some embodiments, the output of each output node in the output layer is

$$O_k = f\left(\sum_j w_{kj} y_j - \theta_k\right)$$ , wherein $w_{kj}$ and $\theta_k$ are respectively a connection weight and a threshold between each output node and each hidden node, $k$ is an index of the output node, and $f$ is a transfer function.

In some embodiments, an activation function of the BP neural network is a Sigmoid function, i.e.

$$f(x) = \frac{1}{1 + e^{-\beta x}}$$ , wherein the parameter $\beta$ can be determined according to the characteristics of the neural network model.

In some embodiments, an error between the output value $O_k$ and an expected output value $t_k$ of the output node in the output layer is $E = \frac{1}{2}\sum_k (t_k - O_k)$ . In some embodiments, an weight correction function in a reverse transfer is

$$\Delta w_{kj} = -\eta \frac{\partial E}{\partial w_{kj}}, \Delta w_{ji} = -\eta \frac{\partial E}{\partial w_{ji}}$$ . In some embodiments, a threshold correction function is

$$\Delta \theta_k = -\eta \frac{\partial E}{\partial \theta_k}, \Delta \theta_j = -\eta \frac{\partial E}{\partial \theta_j}$$ , wherein $\eta$ is between 0.01 ~ 0.8.

In some embodiments, the expected output value $t_k$ comprises a fault number indicating the fault state. As shown in Fig. 2, the fault early warning device for the converter based on multi-information fusion can use binary coding to number the fault state. In some embodiments, the fault degree of the fault state can be described by two bit binary coding, wherein 00 represents a good state, 01 represents a slight fault, 10 represents a moderate fault, and 11 represents a serious fault.

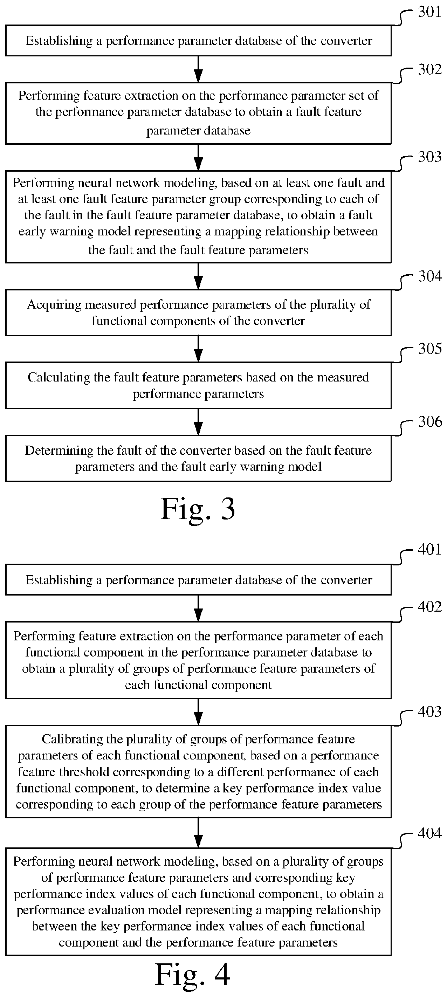

Please refer to Fig. 3, which shows a flowchart of the fault early warning method for the converter according to an embodiment of the present invention.

As shown in Fig. 3, in one embodiment of the invention, after obtaining the fault early warning model representing the mapping relationship between fault and fault feature parameters, the fault early warning method for the converter based on multi-information fusion further comprises the following steps:

304: acquiring measured performance parameters of the plurality of functional components of the converter;

305: calculating the fault feature parameters based on the measured performance parameters; and

306: determining the fault of the converter based on the fault feature parameters and the fault early warning model.

In some embodiments, the fault early warning device for the converter can collect the measured performance parameters of each functional component, by using the sensors arranged **in** each functional component of the traction converter. The measured performance parameters indicate the performance of the corresponding functional components under the current working condition. The working condition of the converter comprises operating environment and mileage of the locomotive where the converter is located.

In some embodiments, the fault early warning device for the converter can perform feature extraction on the obtained measured performance parameter set to calculate corresponding fault feature parameters thereof. By further inputting the calculated fault feature parameters into the hidden layer of the fault early warning model, the fault condition of the converter can be automatically determined, and the fault diagnosis results can be output through the output layer of the fault early warning model.

In some embodiments, the fault early warning device for the converter can output a fault early warning in response to determining that the converter has a fault, so as to prompt a maintenance personnel to repair in time. In some embodiments, the fault early warning device for the converter can also output a corresponding fault early warning according to the fault condition of the converter, so as to prompt the maintenance personnel to repair the corresponding functional components in time.

According to another aspect of the present invention, a state evaluation method for the converter based on multi-information fusion is also provided herein. In some embodiments, the state evaluation method for the converter based on multi-information fusion provided by the invention can be implemented on a state evaluation device for the converter based on multi-information fusion.

Please refer to Fig. 4, which shows a flowchart of a state evaluation method for the converter according to another aspect of the present invention.

As shown in Fig. 4, the state evaluation method for the converter based on multi-information fusion provided by the present invention comprises the following step:

401: establishing a performance parameter database of the converter.

In some embodiments, the performance parameter database comprises a historical performance parameter set that are collected with respect to at least one functional component of the converter, wherein a plurality of groups of performance parameters may be stored in association with each functional component.

In some embodiments, the functional component of the converter comprises all or part of fan, IGBT power module, capacitor, transformer, cabinet lifting lug, heat dissipation system and contactor. In some embodiments, the performance parameter set of the functional component comprises a plurality of functional parameters of the functional component. The performance parameters comprise but are not limited to one or more of vibration parameters, current parameters, voltage parameters, temperature parameters and pressure parameters. In some embodiments, the performance parameters can indicate the performance of the corresponding functional component through specific values. In some embodiments, the state evaluation device for the converter can collect the performance parameters of each functional component by using the sensors arranged in each functional component of the traction converter, so as to establish the performance parameter database of the converter according to the performance parameter set of the plurality of functional components.

In practice, the parameters in the performance parameter database can come from historical data of an on-board data center, actual operation test data of a line, and bench test data in a maintenance base. Preferably, these performance parameters are collected under different working conditions of the converter. The working conditions of the converter comprises operating environment and mileage of the locomotive where the converter is located.

Specifically, **in** some embodiments, the performance parameters of the fan further comprise fan vibration parameters, fan current parameters and fan voltage parameters. **In** some embodiments, the performance parameters of the IGBT power module further comprise module current parameters and IGBT temperature parameters. **In** some embodiments, the performance parameters of the capacitor further comprise capacitor temperature parameters and capacitor current parameters. **In** some embodiments, the performance parameters of the contactor further comprise contactor coil voltage parameters and coil current parameters. **In** some embodiments, the performance parameters of the heat dissipation system further comprise water temperature parameters and water pressure parameters at the inlet and outlet of the converter, and air temperature parameters at the inlet and outlet of the filter. In some embodiments, the performance parameters of the transformer further comprise transformer temperature parameters and transformer vibration parameters.

As shown in Fig. 4, the state evaluation method for the converter based on multi-information fusion provided by the present invention also comprises the following step:

402: performing feature extraction on the performance parameters of each functional component in the performance parameter database to obtain a plurality of groups of performance feature parameters of each functional component.

In some embodiments, each performance feature parameter group comprises a plurality of performance feature parameters for a plurality of functional components of the converter. The performance feature refers to a feature that have certain directivity to the performance of each component of the converter. The performance feature parameter is the specific value of the performance feature, which is related to the quality of performance.

In some embodiments, the performance feature corresponding to the performance feature parameter comprises one or more of vibration intensity, spectrum feature, envelope feature, power factor, unbalance coefficient, negative sequence current and zero sequence current of the fan. **In** some embodiments, the performance feature corresponding to the performance feature parameter comprises one or more of current effective value, current time domain feature and temperature effective value of the IGBT power module. In some embodiments, the performance feature corresponding to the performance feature parameter comprises one or more of temperature effective value, capacitance value and capacitance equivalent series resistance (ESR) value of the capacitor. In some embodiments, the performance feature corresponding to the performance feature parameter comprises one or more of contactor coil resistance and breaking time of the contactor. In some embodiments, the performance feature corresponding to the performance feature parameter comprises one or more of temperature effective value, vibration acceleration effective value and vibration acceleration spectrum feature of the heat dissipation system.

The feature extraction can be implemented through a plurality of iterative verification of converter prototype and line operation performance feature data. The feature extraction of the performance parameter set in the performance parameter database can be realized by combining the performance characteristics of the traction converter, and using mature and reliable feature extraction algorithm in the field, which will not be repeated here.

As shown in Fig. 4, the state evaluation method for the converter based on multi-information fusion provided by the present invention also comprises the following step:

403: calibrating the plurality of groups of performance feature parameters of each functional component, based on performance feature thresholds corresponding to different performances of each functional component, to determine a key performance index value corresponding to each group of the performance feature parameters.

**In** some embodiments, a plurality of groups of performance feature parameters of each functional component can be calibrated based on performance feature thresholds corresponding to different performances of each functional component. Each performance feature threshold corresponds to a critical point between the two quality degrees of one performance. The performance feature threshold here can be an individual threshold corresponding to only one performance feature or a combined threshold corresponding to a combination of performance features.

In some embodiments, the plurality of performance feature thresholds corresponding to various quality degrees of various performances can be determined by performance experiments and / or expert experience of corresponding performances. In some embodiments, the calibrated performance feature parameter can determine a key performance index value according to a belonged threshold range. The key performance index value is between 0~1, used to indicate the quality degree of a corresponding performance.

As shown in Fig. 4, the state evaluation method for the converter based on multi-information fusion provided by the present invention also comprises the following step:

404: performing neural network modeling, based on a plurality of groups of performance feature parameters and corresponding key performance index values of each functional component, to obtain a performance evaluation model representing a mapping relationship between the key performance index values of each functional component and the performance feature parameters.

In some embodiments, the step of performing neural network modeling comprises performing modeling by using a BP neural network model. The BP neural network model comprises an input layer, a hidden layer and an output layer. The input layer comprises an input node of a plurality of performance features corresponding to each group of performance feature parameters of a corresponding functional component. The hidden layer comprises a plurality of hidden nodes. The output layer comprises an output node corresponding to the key performance index value of the functional component.

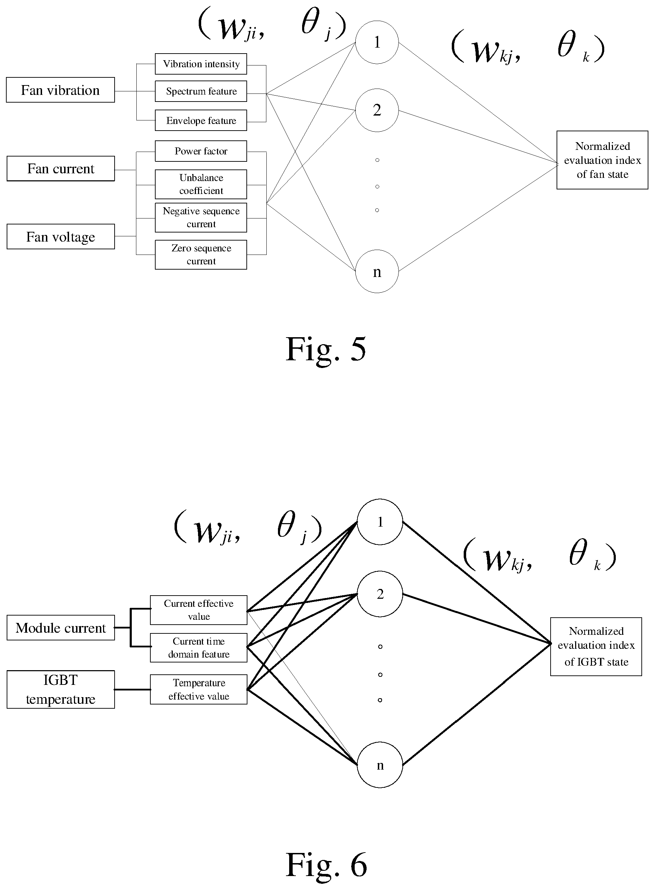

Please refer to Fig. 5, which shows a schematic diagram of a fan condition evaluation model according to an embodiment of the present invention.

As shown in Fig. 5, in some embodiments, the input layer is further divided into a signal layer and a feature layer. The signal layer is original signal measured by the sensor, which comprises fan vibration parameter, fan current parameter and fan voltage parameter. The feature layer is feature parameter obtained by feature extraction and feature operation of each signal, which comprises vibration intensity feature, spectrum feature and envelope feature corresponding to the fan vibration parameter, and power factor feature, three-phase unbalance coefficient feature, negative sequence current feature and zero sequence current feature corresponding to the fan current parameter and the fan voltage parameter. In some embodiments, sample parameter of the input layer can be obtained through performance simulation test and line actual test.

Please refer to Fig. 6, which shows a schematic diagram of a power module state evaluation model according to an embodiment of the present invention.

As shown in Fig. 6, in some embodiments, the signal layer comprises a module current parameter and an IGBT temperature parameter. The feature layer comprises a current effective value feature and a current time domain feature corresponding to the module current parameter, and a temperature effective value feature corresponding to the IGBT temperature parameter.

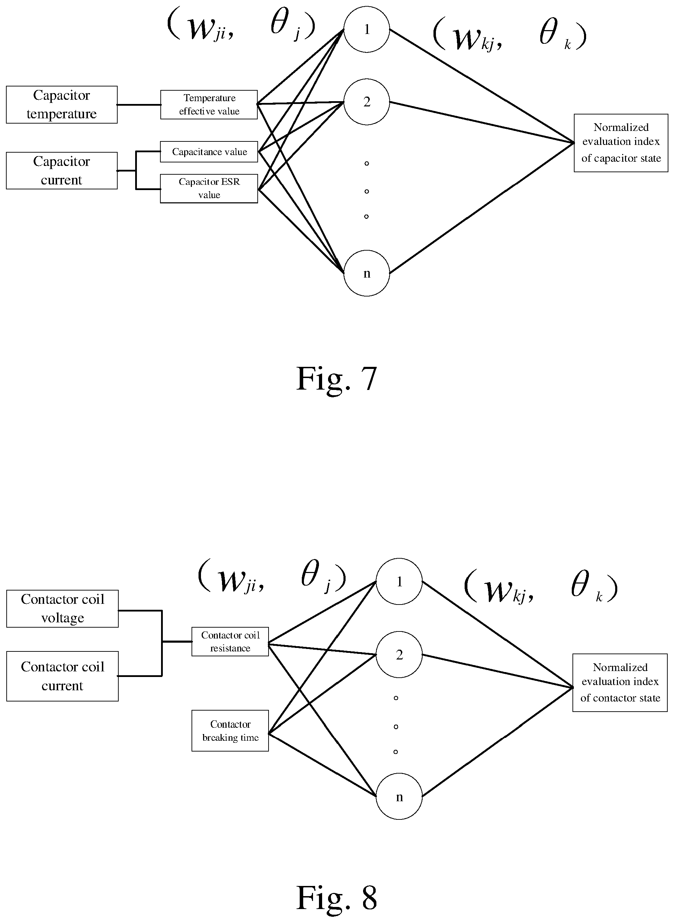

Please refer to Fig. 7, which shows a schematic diagram of a capacitor state evaluation model according to an embodiment of the present invention.

As shown in Fig. 7, in some embodiments, the signal layer comprises a capacitor temperature parameter and a capacitor current parameter. The feature layer comprises a temperature effective value feature corresponding to the capacitor temperature parameter, as well as a capacitance value feature and a capacitor ESR value feature corresponding to the capacitor current parameter.

Please refer to Fig. 8, which a schematic diagram of a contactor state evaluation model according to an embodiment of the present invention.

As shown in Fig. 8, in some embodiments, the signal layer comprises a contactor coil voltage parameter and a contactor coil current parameter. The feature layer comprises a contactor coil resistance feature corresponding to the contactor coil voltage parameter and the contactor coil current parameter, and a contactor breaking time feature.

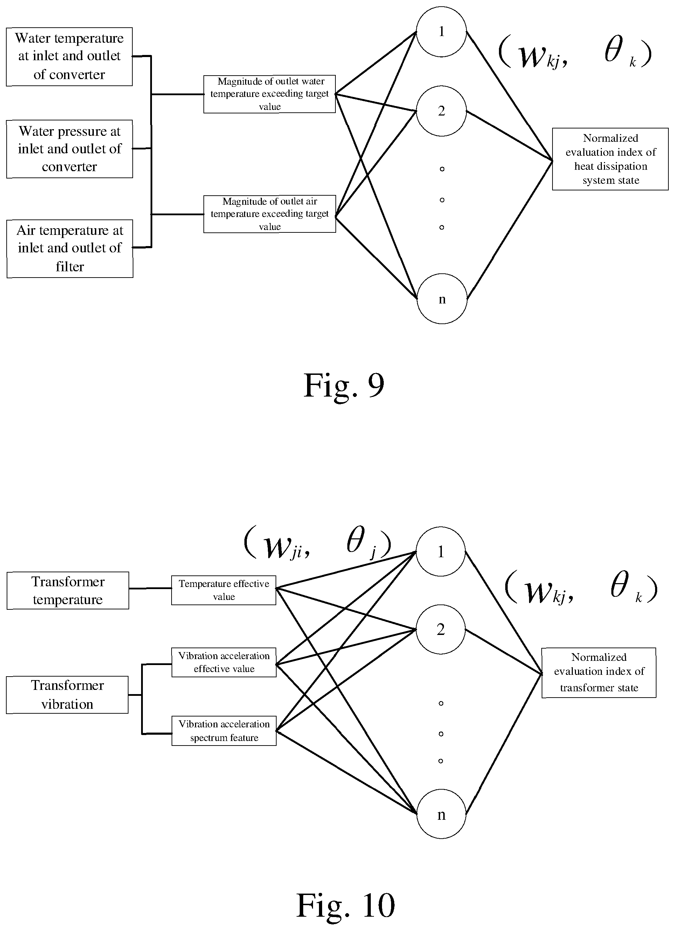

Please refer to Fig. 9, which shows a schematic diagram of a heat dissipation system state evaluation model according to an embodiment of the present invention.

As shown in Fig. 9, in some embodiments, the signal layer comprises water temperature parameters at the inlet and outlet of the converter, water pressure parameters at the inlet and outlet of the converter and air temperature parameters at the inlet and outlet of the converter. The feature layer comprises a magnitude feature of outlet water temperature exceeding target value and a magnitude feature of outlet air temperature exceeding target value, corresponding to the water temperature parameters at the inlet and outlet of the converter, the water pressure parameters at the inlet and outlet of the converter and the air temperature parameters at the inlet and outlet of the converter.

Please refer to Fig. 10, which shows a schematic diagram of a transformer state evaluation model according to an embodiment of the present invention.

As shown in Fig. 10, in some embodiments, the signal layer comprises a transformer temperature parameter and a transformer vibration parameter. The feature layer comprises a temperature effective value feature corresponding to the transformer temperature parameter, as well as a vibration acceleration effective value feature and a vibration acceleration spectrum feature corresponding to the transformer vibration parameter.

In some embodiments, the number of the hidden layer may be one. The number of hidden nodes in the hidden layer can be determined according to the number of input nodes in the input layer and the number of output nodes in the output layer. In some embodiments, the number of the hidden nodes may be a sum of the number of nodes in the input layer and the output layer. In some embodiments, the output of each hidden node in the hidden layer is $y_j = f\left(\sum_i w_{ji} x_i - \theta_j\right)$ , wherein $x_i$ is an input of the input node in the input layer, $w_{ji}$ and $\theta_j$ are respectively a connection weight and a threshold between each hidden node and each input node, $i$ is an index of the input node, and $j$ is an index of the hidden node.

In some embodiments, the output layer may be an output of a corresponding state evaluation result. In some embodiments, the output of each output node in the output layer is $O_k = f\left(\sum_j w_{kj} y_j - \theta_k\right)$ , wherein $w_{kj}$ and $\theta_k$ are respectively a **connection** weight and a threshold between each output node and each hidden node, $k$ is an index of the output node, and $f$ is a transfer function.

In some embodiments, an activation function of the BP neural network is a Sigmoid function, i.e.

$$f(x) = \frac{1}{1 + e^{-\beta x}}$$ , wherein the parameter $\beta$ can be determined according to the characteristics of the neural network model.

In some embodiments, an error between the output value $O_k$ and an expected output value $t_k$ of the output node in the output layer is

$$E = \frac{1}{2} \sum_k (t_k - O_k)$$ . In some embodiments, an weight correction function in a reverse transfer is

$$\Delta w_{kj} = -\eta \frac{\partial E}{\partial w_{kj}}, \Delta w_{ji} = -\eta \frac{\partial E}{\partial w_{ji}}$$ . In some embodiments, a threshold correction function is

$$\Delta \theta_k = -\eta \frac{\partial E}{\partial \theta_k}, \Delta \theta_j = -\eta \frac{\partial E}{\partial \theta_j}$$ , wherein $\eta$ is between $0.01 \sim 0.8$.

In some embodiments, the state evaluation device for the converter based on multi-information fusion can evaluate the state of the converter through a cobweb evaluation system. The expected output value $t_k$ comprises a key performance index value ranging between 0~1.

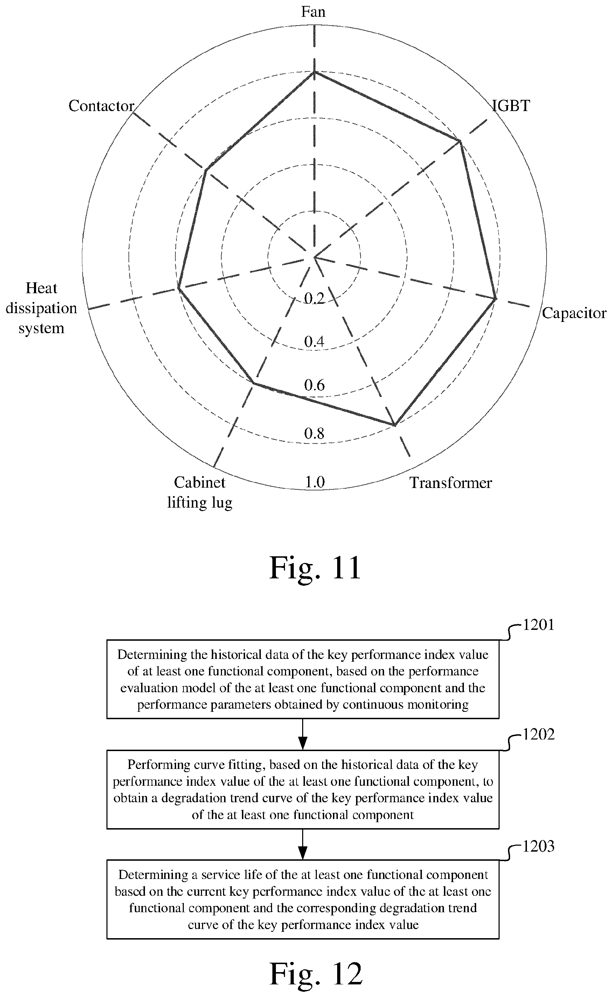

Please refer to Fig. 11, which shows a schematic diagram of a cobweb evaluation system according to an embodiment of the present invention.

As shown in Fig. 11, in some embodiments, the cobweb evaluation system displays the key performance index values of fan, IGBT, capacitor, transformer, cabinet lifting lug, heat dissipation system and contactor at the same time. In some embodiments, 1.0 indicates that the corresponding functional component has good performance; 0.8 indicates a slight performance degradation of the corresponding functional component; 0.6 indicates a performance degradation of the corresponding functional component; 0.4 indicates a serious degradation of the corresponding functional component; 0.2 indicate critical damage of the corresponding functional component; and 0.0 indicates that the corresponding functional component is damaged.

In one embodiment of the present invention, after obtaining the performance evaluation model showing the mapping relationship between the key performance index values and the performance feature parameters, the state evaluation device for the converter based on multi-information fusion can also obtain the performance feature parameter group by using measured performance parameters of at least one functional component, and determine the key performance index value of at least one functional component based on the obtained performance feature parameter group and the performance evaluation model.

In some embodiments, the at least one functional component may be all functional components of the traction converter. In some embodiments, the state evaluation device for the converter can collect the measured performance parameters of each functional component by using the sensors arranged in each functional component of the traction converter. In some embodiments, the state evaluation device for the converter can perform feature extraction on the obtained measured performance parameter set to calculate the corresponding performance feature parameters thereof. By further inputting the calculated performance feature parameters into the hidden layer of the performance evaluation model, the performance state of each functional component of the converter can be automatically determined, and the state evaluation results can be output through the output layer of the performance evaluation model.

Please refer to Fig. 12, which shows a flowchart of a life predicting method for the converter according to an embodiment of the present invention.

As shown in Fig. 12, in one embodiment of the present invention, after obtaining the performance evaluation model showing the mapping relationship between the key performance index values and the performance feature parameters, the state evaluation method for the converter based on multi-information fusion further comprises the following steps:

1201: determining the historical data of the key performance index value of at least one functional component, based on the performance evaluation model of the at least one functional component and the performance parameters obtained by continuous monitoring;

1202: performing curve fitting, based on the historical data of the key performance index value of the at least one functional component, to obtain a degradation trend curve of the key performance index value of the at least one functional component; and

1203: determining a service life of the at least one functional component based on the current key performance index value of the at least one functional component and the corresponding degradation trend curve of the key performance index value.

In some embodiments, the condition evaluation device for the converter based on multi-information fusion can continuously monitor the performance parameters of the functional component whose life is to be predicted, and determine a plurality of historical data of the corresponding key performance index values according to the performance evaluation model of the functional component. Then, the state evaluation device for the converter based on multi-information fusion can obtain a fitting curve by using a fitting method of analytical expression approaching discrete data, that is, the degradation trend curve of the key performance index value of the functional component, and obtain the function expression h(t) of the fitting curve. The function expression h(t) indicates a descending gradient function of the key performance index value of the functional component at time t.

In some embodiments, remaining life $t_{remaining}$ of the functional component can be determined by solving the equation $\Delta I = \int_{0}^{t_{remaining}} h(t)dt$. In the equation, $\Delta I$ is the difference between a current key performance index value and a preset key performance index value threshold of the functional component to be predicted. By the fitting curve and the function expression h(t) thereof, the descending trend of the key performance index value of the functional component to be predicted can be simulated, so as to calculate a future trend of the key performance index value of the functional component to be predicted, and predict the remaining life $t_{remaining}$ of the functional component to be predicted. It can be understood that the remaining life $t_{remaining}$ of the functional component to be predicted refers to the time required for the decline from the current key performance index value of the functional component to the preset key performance index value threshold.

In some embodiments, the state evaluation device for the converter based on multi-information fusion can determine the minimum life of at least one functional component as the life of the converter.

Based on the above description, the fault early warning method for the converter based on multi-information fusion and the state evaluation method for the converter based on multi-information fusion proposed by the present invention can perform feature extraction and feature fusion of multi-dimensional signals of current, voltage, vibration and temperature of the fan, the capacitor, the IGBT, the contactor, the transformer, the reactor, the heat dissipation system and the lifting lug during the operation of the converter, to establish a fault early warning model based on feature fusion, so as to accurately locate each functional device in the converter. The fault early warning method for the converter based on multi-information fusion can also establish a multi-dimensional state evaluation system of the above key materials, systems and structures by fully refining and mining the existing standards, expert experience and previous data, so as to realize intelligent monitoring and evaluation of the working state of the converter. The fault early warning method for the converter based on multi-information fusion can predict the failure time and mode of the key materials and predict the life of the key materials of the converter by deeply learning the key performance index and fault evolution trend of the whole life cycle of the key materials of the converter, and by the established current status, operating mileage and environment of the key materials.

Although the method is illustrated and described as a series of actions for the purpose of simplifying the explanation, it should be understood and appreciated that these methods are not limited by the order of the actions. Those skilled in the art may understand that some actions may occur in different orders and/or concurrently with other actions that are illustrated and described herein or that are not illustrated and described herein, in accordance with one or more embodiments.

According to another aspect of the present invention, a fault early warning device for a converter based on multi-information fusion is also provided herein.

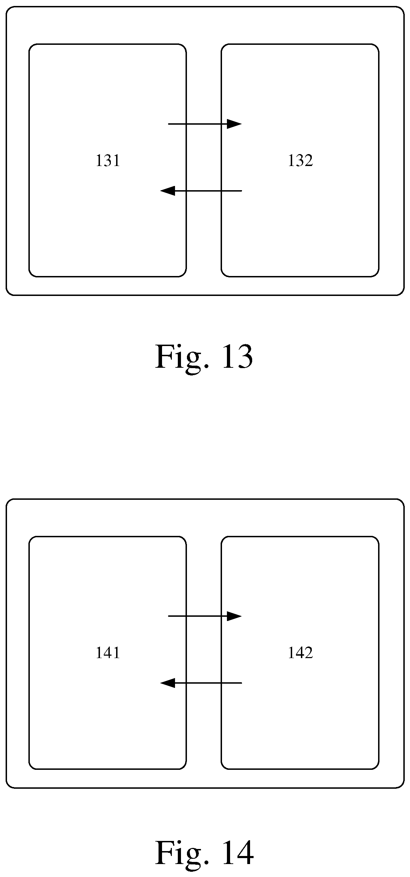

Please refer to Fig. 13, which shows a structural diagram of the fault early warning device for the converter according to another aspect of the present invention.

As shown in Fig. 13, the fault early warning device for the converter based on multi-information fusion provided by the invention comprises a memory 131 and a processor 132. In some embodiments, the processor 132 is coupled to the memory 131 and configured to implement the fault early warning method for the converter based on multi-information fusion provided by any one of the above embodiments, so as to monitor the operation status of the traction converter in real time, as well as perform early warning and accurate positioning of the fault of the traction converter.

According to another aspect of the present invention, a computer-readable medium is also provided herein.

The computer-readable medium provided by the present invention stores a computer executable instruction. When the computer executable instruction is executed by the processor 132, any one of the fault early warning methods for the converter based on multi-information fusion can be implemented, so as to monitor the operation status of the traction converter in real time, as well as perform early warning and accurate positioning of the fault of the traction converter.

According to another aspect of the present invention, a state evaluation device for the converter based on multi-information fusion is also provided herein.

Please refer to Fig. 14, which shows a structural diagram of a state evaluation device for the converter according to another aspect of the present invention.

As shown in Fig. 14, the state evaluation device for the converter based on multi-information fusion provided by the present invention comprises a memory 141 and a processor 142. In some embodiments, the processor 142 is coupled to the memory 141 and configured to implement the state evaluation method for the converter based on multi-information fusion provided by any one of the above embodiments, so as to monitor the operation status of the traction converter in real time, as well as predict the service life of the traction converter.

According to another aspect of the invention, a computer-readable medium is also provided herein.

The computer-readable medium provided by the present invention stores a computer executable instruction. When the computer executable instruction is executed by the processor 142, the state evaluation method for the converter based on multi-information fusion provided by any one of the above embodiments can be implemented, so as to monitor the operation status of the traction converter in real time, as well as predict the service life of the traction converter.

Although the processors 132 and 142 described in the above embodiment can be implemented by a combination of software and hardware, it is understood that the processors 132 and 142 can also be implemented separately in software or hardware. For hardware implementation, the processors 132 and 142 can be implemented in one or more application specific integrated circuits (ASICs), digital signal processors (DSPS), programmable logic device (PLD), field programmable gate array (FPGA), processor, controller, microcontroller, microprocessor, other electronic devices for performing the above functions, or selected combinations of the above devices. For software implementation, the processors 132 and 142 can be implemented through independent software modules such as procedures, functions, etc. running on a general-purpose chip, each of which can perform one or more of the functions and operations described herein.

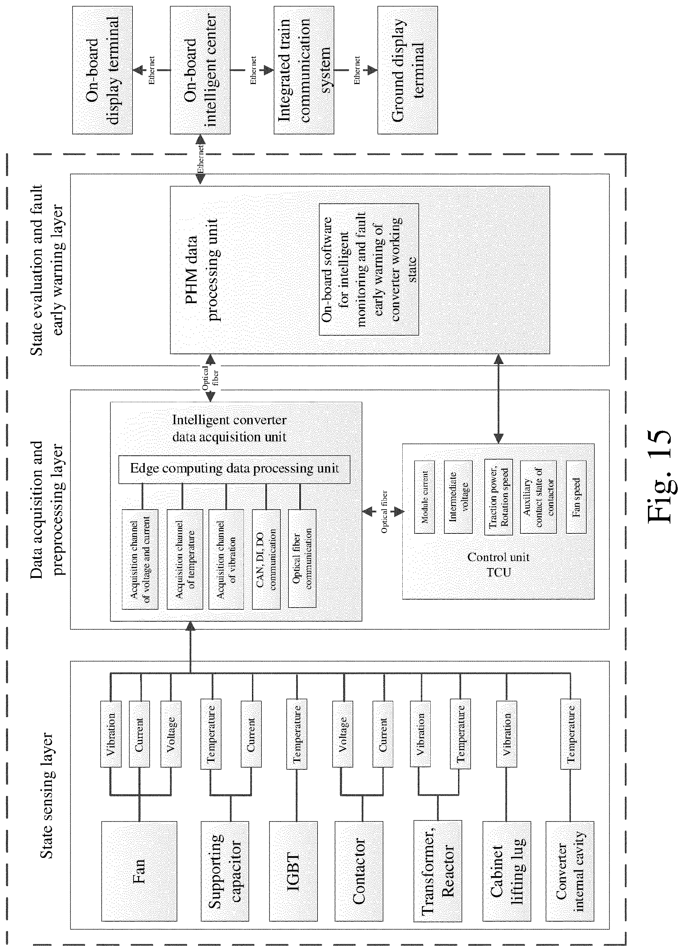

Based on the above multi-information fusion proposals of fault early warning, state evaluation and life prediction, an intelligent platform for condition monitoring and fault early warning of converter can be developed, as shown in Fig. 15. The intelligent platform mainly comprises a state sensing layer, a data acquisition and preprocessing layer, and a state evaluation and fault early warning layer.

The state sensing layer can be composed of various sensors to realize the sensing of fan vibration, current and voltage, supporting capacitor temperature and current, IGBT temperature, contactor voltage and current, cabinet lifting lug vibration, transformer vibration and temperature, converter flow channel temperature, and transmit the sensed physical quantities to the acquisition system in the form of analog quantities. Herein, it is necessary to select sensors with high reliability and good stability, wherein the measurement frequency range of the sensors shall cover the whole fault feature frequency, the measurement accuracy of the sensors shall meet the requirements of feature extraction, the requirements of the converter service conditions shall be meted, and the installation shall be firm and reliable.

The core of the data acquisition and preprocessing layer is used in the A/D acquisition module for analog quantity acquisition and the data processing unit for front-end edge computing, which can realize the acquisition of analog quantities such as current, voltage, vibration and temperature in the state sensing layer, as well as the acquisition of the intermediate voltage, rotation speed, power, input current of sorting module, output current of inverter module, fan speed and contact state of contactor by performing communication between optical fiber and TCU. After acquiring the analog signals transmitted in the state sensing layer and the TCU, performing segmentation and selection on the data structure, and performing simple Fourier analysis and state feature calculation on the data after operation, the processed data is transmitted to the state evaluation and fault early warning layer through the optical fiber.

The hardware core of the state evaluation and fault early warning layer is a PHM (prediction and health management) data processing unit, and the software core is a working state intelligent monitoring and fault early warning software for the converter. The main function is to extract the feature and calculate the state evaluation index of the transmitted data, perform accurate evaluation and fault early warning on the operation status of fan, capacitor, IGBT, contactor, auxiliary transformer and heat dissipation system according to the established state evaluation system and fault diagnosis model, perform evaluation and early warning on the status of vibration load, dynamic stress and ambient temperature of converter cabinet, predict the service life of IGBT, fan, capacitor and contactor, and transmit the status evaluation information and the fault early warning information to the on-board intelligent center through Ethernet. The operation performance of PHM data analysis unit can be configured according to the requirements of operation and storage capacity.

The working mode of the intelligent converter condition monitoring and fault early warning system is to pick up key state characteristics through the sensors of the state sensing layer and convert them into analog quantities for online transmission. The data acquisition and preprocessing layer collects the analog signals from the sensing layer, performs interception, selection and front-end operation on the data according to pre-determined rules and modes to convert them into digital signals, and transmits them to an upper layer. The state evaluation and fault early warning layer receives the data from the acquisition layer, calculates the state feature index and extracts the fault feature, then uses the existing state evaluation system, fault model and life prediction model to carry out fault early warning, state evaluation and life prediction respectively, and finally transmits the information to the on-board intelligent center and a ground operation and maintenance center to formulate the intelligent operation and maintenance strategy.

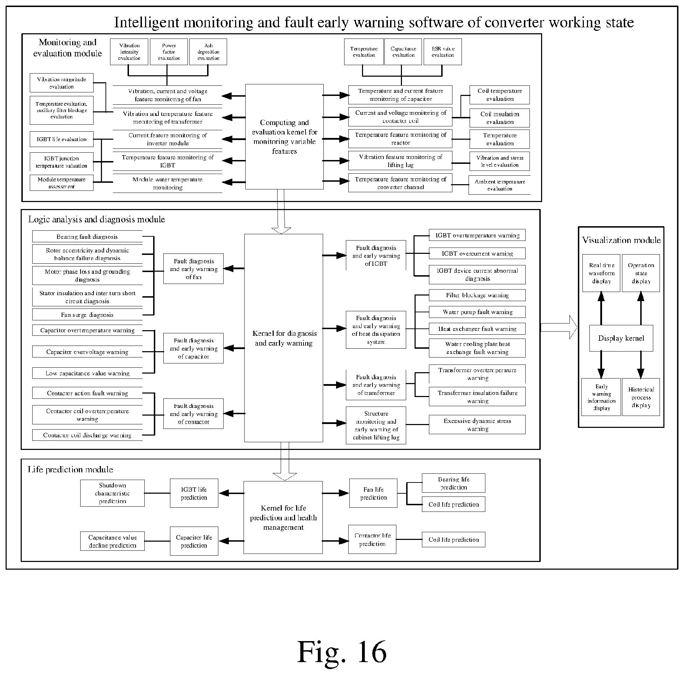

In addition, a set of intelligent monitoring and fault early warning software for converter working state can be developed based on the above multi-information fusion fault early warning, condition evaluation and life prediction proposals. As shown in Fig. 16, the software comprises a condition monitoring and evaluation module, a logic analysis and diagnosis module, a life prediction module and a visualization module.

The core of the condition monitoring and evaluation module is the state feature operation rules and evaluation system established for the whole converter cabinet and key materials. Vibration, current and voltage of the fan are monitored to realize the evaluation of vibration intensity, power factor and ash deposition degree of the fan. Capacitor temperature and current features of the capacitor are monitored to realize the evaluation of capacitance value, EST value and temperature of the capacitor. Water temperature of the inverter module, IGBT temperature and inverter module current are monitored to realize the evaluation of junction temperature, service life and module operating temperature of the IGBT. Current and voltage of the contactor coil are monitored to realize the evaluation of coil temperature and coil insulation of the contactor. Temperatures of the transformer, the reactor, the capacitor and the internal cavity are monitored to realize the evaluation of the converter ambient temperature and operation state of the transformer and the reactor. Vibration of the transformer is monitored to realize the evaluation of vibration of the transformer. Vibration of the lifting lug of the converter is monitored to realize the evaluation of load environment of the converter and dynamic stress of the lifting lug.

The core of the logic analysis and diagnosis module is the fault diagnosis and early warning model established for the fan, the capacitor, the contactor, the IGBT, the heat dissipation system and the cabinet lifting lug. Vibration of the fan is monitored to realize fault diagnosis and early warning of bearing, rotor eccentricity and dynamic balance failure. Current and voltage of the fan are monitored to realize fault diagnosis and early warning of fan phase loss, grounding, stator insulation and inter turn short circuit fault. Temperature, pressure, current and intermediate voltage of the capacitor are monitored to realize early warning of overtemperature, overvoltage and excessive decrease of capacitance value of the capacitor. Current, voltage and control command of the contactor are monitored to realize diagnosis and early warning of action fault, coil overtemperature and discharge fault of the contactor. Current and intermediate voltage of the IGBT and water cooling plate temperature are monitored to realize early warning of overtemperature, overcurrent and current abnormality of the IGBT. Temperature of various key materials and the internal cavity of the converter, module water temperature, flow, traction power, speed and fan speed are monitored to realize diagnosis and early warning of filter screen blockage fault, water pump fault, heat exchanger fault and heat conduction fault of the water-cooled plate. Temperature and current of the transformer are monitored to realize early warning of overtemperature and insulation failure of the transformer. Vibration of the cabinet lifting lug is monitored to realize early warning of excessive dynamic load of the lifting lug.

The core of the life prediction module is the life prediction model for the IGBT, the capacitor, the fan and the contactor. Service life of the IGBT, the capacitor, the fan and the contactor is predicted by monitoring the evolution law of shutdown characteristics of the IGBT, capacitance value, insulation of the fan bearing and the coil, and the contactor coil aging.

The visualization module is mainly used to display real-time fault waveform, operation state evaluation diagram, early warning information and historical process data, which has a good display effect, wherein a normalized cobweb diagram is proposed to be used for the operation state evaluation diagram.

Those skilled in the art will understand that information, signals and data can be represented by using any of various different technologies and techniques. For example, data, instructions, commands, information, signals, bits, code elements and chips, quoted throughout the above description, may be represented by voltage, current, electromagnetic wave, magnetic field or magnetic particle, optical field or optical particle, or any combination thereof.

Those skilled in the art will further appreciate that various illustrative logic blocks, modules, circuits, and algorithm steps described in connection with the embodiments disclosed herein may be implemented as electronic hardware, computer software, or a combination of the two. In order to clearly explain this interchangeability of hardware and software, various illustrative components, frames, modules, circuits, and steps are generally described in the form of their functionality. Whether such functionality is implemented as hardware or software depends on the specific application and the design constraints imposed on the overall system. Technicians may implement the described functionality in different ways for each specific application, but such implementation decisions should not be interpreted as leading to departure from the scope of the present invention.

The various illustrative logic modules and circuits described in connection with the embodiments disclosed herein may be realized or executed by a general-purpose processor, a digital signal processor (DSP), an application specific integrated circuit (ASIC), a field programmable gate array (FPGA) or other programmable logic devices, discrete gate or transistor logic devices, discrete hardware components or any combination designed to perform the functions described herein. The general-purpose processor may be a microprocessor, but in an alternative, the processor may be any conventional processor, controller, microcontroller, or state machine. The processor may also be implemented as a combination of computing devices, such as a combination of DSP and microprocessor, a plurality of microprocessors, one or more microprocessors cooperating with a DSP core, or any other such configuration.

The steps of the method or algorithm described in connection with the embodiments disclosed herein may be embodied directly in a hardware, in a software module executed by a processor, or in a combination of the two. The software module may reside in a RAM memory, a flash memory, a ROM memory, an EPROM memory, an EEPROM memory, a register, a hard disk, a removable disk, a CD-ROM, or any other form of storage medium known in the art. An exemplary storage medium is coupled to the processor, so that the processor can read and write information from / to the storage medium. In an alternative proposal, the storage medium may be integrated into the processor. The processor and the storage medium may reside in an ASIC. The ASIC may reside in a user terminal. In an alternative proposal, the processor and the storage medium may reside in the user terminal as discrete components.

In one or more exemplary embodiments, the described functions may be implemented in a hardware, a software, a firmware, or any combination thereof. If implemented as a computer program product in the software, each function can be stored on or transmitted through a computer-readable medium as one or more instructions or codes. The computer-readable medium comprises both a computer storage medium and a communication medium, comprising any medium that facilitates the transfer of a computer program from one place to another. The storage medium can be any available medium that can be accessed by a computer. By way of example but not limitation, such a computer-readable medium may comprise a RAM, a ROM, an EEPROM, a CD-ROM or other optical disk storage, magnetic disk storage or other magnetic storage device, or any other medium that can be used to carry or store desired program code in the form of instructions or data structures, and can be accessed by a computer. Any connection is also properly referred to as a computer-readable medium. For example, if the software is transmitted from a web site, a server, or other remote source by using a coaxial cable, an optical fiber cable, a twisted pair, a digital subscriber line (DSL), or wireless technologies such as infrared, radio and microwave, the coaxial cable, the optical fiber cable, the twisted pair, the DSL, or the wireless technologies such as infrared, radio and microwave are comprised in the definition of the medium. The disks and discs used herein comprise compact discs (CD), laser discs, optical discs, digital versatile discs (DVD), floppy disks and Blu-ray discs, wherein the disks often reproduce data magnetically, while the discs often reproduce data optically with lasers. The above combinations shall also be comprised in the scope of the computer-readable media.

The previous description of the present disclosure is provided to enable any person skilled in the art to make or use the present disclosure.

**Claims**

1.  A fault early warning method for a converter based on multi-information fusion, **characterised by**:

    establishing a performance parameter database of the converter (101, 301, 401), wherein the performance parameter database comprises a performance parameter set of a plurality of functional components of the converter collected when at least one fault occurs;
    performing feature extraction on the performance parameter set of the performance parameter database to obtain a fault feature parameter database (102, 302), wherein the fault feature parameter database comprises at least one fault and at least one fault feature parameter group corresponding to each of the fault, and each of the fault feature parameter group comprises a plurality of fault feature parameters, related to a plurality of functional components of the converter; and
    performing neural network modeling, based on at least one fault and at least one fault feature parameter group corresponding to each of the fault in the fault feature parameter database, to obtain a fault early warning model representing a mapping relationship between the fault and the fault feature parameters (103, 303);
    calibrating the fault feature parameters in the fault feature parameter database, based on a fault feature threshold corresponding to a fault degree of each fault, to determine the fault degree of the fault corresponding to each of the fault feature parameter group,
    the step of performing neural network modeling based on at least one fault and at least one fault feature parameter group corresponding to each of the fault in the fault feature parameter database comprises: performing neural network modeling based on a fault state of the at least one fault and the at least one fault feature parameter group corresponding to each of the fault state in the fault feature parameter database, wherein the fault state comprises a fault type and the fault degree corresponding to each of the fault type.

2. The fault early warning method of claim 1, wherein the step of performing neural network modeling comprises performing modeling by using a BP neural network model, the BP neural network model comprises an input layer, a hidden layer and an output layer, the input layer comprises input nodes related to a plurality of fault features corresponding to the plurality of fault feature parameters in the fault feature parameter group, and the output layer comprises output nodes of the at least one fault state.

3. The fault early warning method of claim 2, wherein an output of each hidden node in the hidden layer is

$$y_j = f\left(\sum_i w_{ji} x_i - \theta_j\right)$$, wherein $x_i$ is an input

of the input node of the input layer, $w_{ji}$ and $\theta_j$ are respectively a connection weight and a threshold between each hidden node and each input node, i is an index of the input node, and j is an index of the hidden node,
an output of each output node in the output layer is

$$O_k = f\left(\sum_j w_{kj} y_j - \theta_k\right)$$, wherein $w_{kj}$ and $\theta_k$

*are* respectively a connection weight and a threshold between each output node and each hidden node, and *k* is an index of the output node.

4. The fault early warning method of claim 3, wherein activation function of the BP neural network is a sigmoid function.

5. The fault early warning method of claim 3, , wherein an error between the output value $O_k$ and an expected output value $t_k$ of the output node of the output layer is $E = \frac{1}{2}\sum_k (t_k - O_k)$, an weight correction

function in a reverse transfer is

$$\Delta w_{kj} = -\eta \frac{\partial E}{\partial w_{kj}}, \Delta w_{ji} = -\eta \frac{\partial E}{\partial w_{ji}},$$

and a threshold correction function is

$$\Delta \theta_k = -\eta \frac{\partial E}{\partial \theta_k}, \Delta \theta_j = -\eta \frac{\partial E}{\partial \theta_j}$$, wherein η

is between 0.01 ~ 0.8.

6. The fault early warning method of claim 5, wherein the expected output value comprises a fault number indicating the fault state.

7. The fault early warning method of claim 1, wherein type of the fault comprises one or more of the following: bearing inner ring fault, bearing outer ring fault, bearing ball fault, bearing cage fault, fan dynamic balance failure fault, fan phase loss fault, fan inter turn short circuit fault, fan phase imbalance fault, fan grounding fault, fan surge fault, capacitor overtemperature fault, capacitance loss fault, IGBT overtemperature fault, IGBT overcurrent fault, filter blockage fault, water pump fault, heat exchanger fault, water cooling plate fault, transformer overtemperature fault and transformer insulation failure fault.

8. The fault early warning method of claim 1, wherein fault feature corresponding to the fault feature parameter comprises one or more of the following: total value feature, spectrum feature and envelope feature about fan vibration, power factor, unbalance coefficient, negative sequence current, zero sequence current, spectrum feature, envelope feature and energy feature about fan current, temperature effective value and temperature change gradient about transformer temperature, current effective value and current time domain feature about module current, harmonic feature of converter intermediate voltage, temperature effective value and temperature change gradient of IGBT temperature, total value feature and spectrum feature of capacitor current, temperature effective value and temperature change gradient of water temperature at inlet and outlet of the converter, effective value of water pressure at the inlet and outlet of the converter, and temperature effective value of air temperature at inlet and outlet of a filter.

9. The fault early warning method of claim 1, further comprising:

acquiring measured performance parameters of the plurality of functional components of the converter (304);
calculating the fault feature parameters based on the measured performance parameters (305); and
determining the fault of the converter based on the fault feature parameters and the fault early warning model (306).

10. The fault early warning method of claim 1, wherein the performance parameter set corresponding to each fault is collected under different working conditions of the converter, and the working conditions comprise operating environment and mileage of a locomotive where the converter is located.

11. A fault early warning device for a converter based on multi-information fusion, comprising:

> a memory; and
> a processor, configured to perform the method of any one of claims 1-10.

12. A computer-readable medium, storing a computer executable instruction, wherein when the computer executable instruction is executed by a processor, the method of any one of claims **1-10** is implemented.

## Patentansprüche

1. Ein Fehlerfrühwarnverfahren für einen Wandler basierend auf Multi-Informationsfusion, **gekennzeichnet durch**:

> Erstellen einer Leistungsparameterdatenbank des Wandlers (101, 301, 401), wobei die Leistungsparameterdatenbank einen Leistungsparametersatz einer Mehrzahl von Funktionskomponenten des Wandlers aufweist, die gesammelt werden, wenn zumindest ein Fehler auftritt;
> Durchführen einer Merkmalsextraktion an dem Leistungsparametersatz der Leistungsparameterdatenbank, um eine Fehlermerkmalsparameterdatenbank (102, 302) zu erhalten, wobei die Fehlermerkmalsparameterdatenbank zumindest einen Fehler und zumindest eine Fehlermerkmalsparametergruppe aufweist, die jedem der Fehler entspricht, und jede der Fehlermerkmalsparametergruppe eine Mehrzahl von Fehlermerkmalsparametern aufweist, die sich auf eine Mehrzahl von Funktionskomponenten des Wandlers beziehen; und
> Durchführen einer Modellierung eines neuralen Netzwerks, basierend auf zumindest einem Fehler und zumindest einer Fehlermerkmalsparametergruppe, die jedem der Fehler in der Fehlermerkmalsdatenbank entspricht, um ein Fehlerfrühwarnmodell zu erhalten, das eine Abbildungsbeziehung zwischen dem Fehler und den Fehlermerkmalsparametern (103, 303) darstellt;
> Kalibrieren der Fehlermerkmalsparameter in der Fehlermerkmalsparameterdatenbank, basierend auf einem Fehlermerkmalsschwellenwert, der einem Fehlergrad jedes Fehlers entspricht, um den Fehlergrad des Fehlers zu bestimmen, der jeder der Fehlermerkmalsparametergruppen entspricht,
> wobei der Schritt des Durchführens einer Modellierung eines neuralen Netzwerks basierend auf zumindest einem Fehler und zumindest einer Fehlermerkmalsparametergruppe, die jedem der Fehler in der Fehlermerkmalsparameterdatenbank entspricht, folgende Schritte aufweist:

> Durchführen einer Modellierung eines neuralen Netzwerks basierend auf einem Fehlerzustand des zumindest einen Fehlers und der **zumindest** einen Fehlermerkmalsparametergruppe, die jedem der Fehlerzustände in der Fehlermerkmalsparameterdatenbank entspricht, wobei der Fehlerzustand einen Fehlertyp und den Fehlergrad aufweist, der jedem der Fehlertypen entspricht.

2. Das Fehlerfrühwarnverfahren gemäß Anspruch 1, wobei der Schritt des Durchführens einer Modellierung eines neuralen Netzwerks ein Durchführen einer Modellierung unter Verwendung eines neuralen BP-Netzwerkmodells aufweist, wobei das neurale BP-Netzwerkmodell eine Eingangsschicht, eine verborgene Schicht und eine Ausgangsschicht aufweist, wobei die Eingangsschicht Eingangsknoten aufweist, die sich auf eine Mehrzahl von Fehlermerkmalen beziehen, die der Mehrzahl von Fehlermerkmalsparametern in der Fehlermerkmalsparametergruppe entsprechen, und die Ausgangsschicht Ausgangsknoten des zumindest einen Fehlerzustands aufweist.

3. Das Fehlerfrühwarnverfahren gemäß Anspruch 2, wobei eine Ausgabe von jedem verborgenen Knoten in der verborgenen Schicht

$$y_j = f\left(\sum_i w_{ji}x_i - \theta_j\right)$$ beträgt, wobei $x_i$ eine Eingabe des Eingangsknoten der Eingangsschicht ist, $w_{ji}$ und $\theta_j$ jeweils ein Verbindungsgewicht und einen Schwellenwert zwischen jedem verborgenen Knoten und jedem Eingangsknoten sind, $i$ ein Index des Eingangsknoten ist *und j* ein Index des verborgenen Knotens ist,
eine Ausgabe jedes Ausgangsknotens in der Ausgangsschicht $$O_k = f\left(\sum_j w_{kj}y_j - \theta_k\right)$$ ist, wobei $w_{kj}$ und $\theta_k$ jeweils ein Verbindungsgewicht und ein Schwellenwert zwischen jedem Ausgangsknoten und jedem verborgenen Knoten sind und $k$ ein Index des Ausgangsknotens ist.

4. Das Fehlerfrühwarnverfahren gemäß Anspruch 3, wobei eine Aktivierungsfunktion des neuralen BP-Netzwerks eine Sigmoidfunktion ist.

5. Das Fehlerfrühwarnsystem gemäß Anspruch 3, bei dem ein Fehler zwischen dem Ausgangswert $O_k$ und einem erwarteten Ausgangswert $t_k$ des Ausgangsknotens der **Ausgangsschicht**

$$E = \frac{1}{2}\sum_k(t_k - O_k)$$ ist, eine Gewichtskorrektur-

funktion in einer umgekehrten Übertragung

$$\Delta w_{kj} = -\eta \frac{\partial E}{\partial w_{kj}}, \; \Delta w_{ji} = -\eta \frac{\partial E}{\partial w_{ji}}$$ ist und eine

Schwellenwertkorrekturfunktion

$$\Delta \theta_k = \eta \frac{\partial E}{\partial \theta_k}, \; \Delta \theta_j = \eta \frac{\partial E}{\partial \theta_j}$$ ist, wobei $\eta$ zwischen

0,01 - 0,8 liegt.

6. Das Fehlerfrühwarnverfahren gemäß Anspruch 5, wobei der erwartete Ausgangswert eine Fehlerzahl aufweist, die den Fehlerzustand angibt.

7. Das Fehlerfrühwarnverfahren gemäß Anspruch 1, wobei der Typ des Fehlers eines oder mehrere der folgenden aufweist: Lagerinnenringfehler, Lageraußenringfehler, Lagerkugelfehler, Lagerkäfigfehler, Dynamisches-Gleichgewicht-Ausfallfehler des Lüfters, Lüfterphasenverlustfehler, Lüfterwindungskurzschlussfehler, Lüfterphasenungleichgewichtsfehler, Lüftererdungsfehler, Lüfterüberspannungsfehler, Kondensatorübertemperaturfehler, Kapazitätsverlustfehler, IGBT-Übertemperaturfehler, IGBT-Überstromfehler, Filterblockierungsfehler, Wasserpumpenfehler, Wärmetauscherfehler, Wasserkühlplattenfehler, Transformatorübertemperaturfehler und Transformatorisolationsausfallfehler.

8. Das Fehlerfrühwarnverfahren gemäß Anspruch 1, wobei das Fehlermerkmal, das dem Fehlermerkmalsparameter entspricht, eines oder mehrere der folgenden aufweist: Gesamtwertmerkmal, Spektrumsmerkmal und Hüllkurvenmerkmal bezüglich Lüftervibration, Leistungsfaktor, Ungleichgewichtskoeffizient, Gegenstrom, Nullstrom, Spektrumsmerkmal, Hüllkurvenmerkmal und Energiemerkmal bezüglich Lüfterstrom, effektiver Temperaturwert und Temperaturänderungsgradient bezüglich Transformatortemperatur, effektiver Stromwert und Stromzeitbereichsmerkmal bezüglich Modulstrom, harmonisches Merkmal einer Wandlerzwischenspannung, effektiver Temperaturwert und Temperaturänderungsgradient der IGBT-Temperatur, Gesamtwertmerkmal und Spektrumsmerkmal des Kondensatorstroms, effektiver Temperaturwert und Temperaturänderungsgradient der Wassertemperatur an dem Einlass und Auslass des Wandlers, effektiver Wert des Wasserdrucks an dem Einlass und Auslass des Wandlers und effektiver Temperaturwert der Lufttemperatur an einem Einlass und Auslass eines Filters.

9. Das Fehlerfrühwarnverfahren gemäß Anspruch 1, das ferner folgende Schritte aufweist:

Erfassen von gemessenen Leistungsparametern der Mehrzahl von Funktionskomponenten des Wandlers (304);

Berechnen der Fehlermerkmalsparameter basierend auf den gemessenen Leistungsparametern (305); und
Bestimmen des Fehlers des Wandlers basierend auf den Fehlermerkmalsparametern und dem Fehlerfrühwarnmodell (306).

10. Das Fehlerfrühwarnverfahren gemäß Anspruch 1, wobei der Leistungsparametersatz, der jedem Fehler entspricht, unter unterschiedlichen Arbeitsbedingungen des Wandlers gesammelt wird und die Arbeitsbedingungen eine Betriebsumgebung und eine Fahrleistung einer Lokomotive aufweisen, wo sich der Wandler befindet.

11. Eine Fehlerfrühwarnvorrichtung für einen Wandler basierend auf Multi-Informationsfusion, die folgende Merkmale aufweist:

einen Speicher; und
einen Prozessor, der dazu konfiguriert ist, das Verfahren gemäß einem der Ansprüche 1-10 durchzuführen.

12. Ein computerlesbares Medium, das eine computerausführbare Anweisung speichert, wobei, wenn die computerausführbare Anweisung durch einen Prozessor ausgeführt wird, das Verfahren gemäß einem der Ansprüche 1-10 implementiert wird.

**Revendications**

1. Méthode d'avertissement précoce de défaut pour un convertisseur basée sur la fusion de multiples informations, **caractérisée par** :

l'établissement d'une base de données de paramètres de performance du convertisseur (101, 301, 401), dans laquelle la base de données de paramètres de performance comprend un ensemble de paramètres de performance d'une pluralité de composants fonctionnels du convertisseur collectés lorsqu'au moins un défaut se produit ;
la réalisation d'une extraction de caractéristiques sur l'ensemble de paramètres de performance de la base de données de paramètres de performance pour obtenir une base de données de paramètres de caractéristiques de défaut (102, 302), dans laquelle la base de données de paramètres de caractéristiques de défaut comprend au moins un défaut et au moins un groupe de paramètres de caractéristiques de défaut correspondant à chacun des défauts, et chacun des groupes de paramètres de caractéristiques de défaut comprend une pluralité de paramètres de caractéristiques de défaut, liés à une pluralité de composants fonctionnels du convertisseur ; et

la réalisation d'une modélisation par réseau neural, sur la base d'au moins un défaut et d'au moins un groupe de paramètres de caractéristiques de défaut correspondant à chacun des défauts dans la base de données de paramètres de caractéristiques de défaut, pour obtenir un modèle d'avertissement précoce de défaut représentant une relation de mise en correspondance entre le défaut et les paramètres de caractéristiques de défaut (103, 303) ; l'étalonnage des paramètres de caractéristiques de défaut dans la base de données de paramètres de caractéristiques de défaut, sur la base **d'un** seuil de caractéristique de défaut correspondant à un degré de défaut de chaque défaut, pour déterminer le degré de défaut du défaut correspondant à chacun des groupes de paramètres de caractéristiques de défaut, l'étape de réalisation d'une modélisation par réseau neural sur la base d'au moins un défaut et d'au moins un groupe de paramètres de caractéristiques de défaut correspondant à chacun des défauts dans la base de données de paramètres de caractéristiques de défaut comprend : la réalisation d'une modélisation par réseau neural sur la base d'un état de défaut de l'au moins un défaut et de l'au moins un groupe de paramètres de caractéristiques de défaut correspondant à chacun de l'état de défaut dans la base de données de paramètres de caractéristiques de défaut, dans laquelle l'état de défaut comprend un type de défaut et le degré de défaut correspondant à chacun des types de défauts.

2. Méthode d'avertissement précoce de défaut selon la revendication **1,** dans laquelle l'étape de réalisation d'une modélisation par réseau neural comprend la réalisation d'une modélisation à l'aide d'un modèle de réseau neural BP, le modèle de réseau neural BP comprend une couche d'entrée, une couche cachée et une couche de sortie, la couche d'entrée comprend des nœuds d'entrée liés à une pluralité de caractéristiques de défaut correspondant à la pluralité de paramètres de caractéristiques de défaut dans le groupe de paramètres de caractéristiques de défaut, et la couche de sortie comprend des nœuds de sortie de l'au moins un état de défaut.

3. Méthode d'avertissement précoce de défaut selon la revendication 2, dans laquelle une sortie de chaque nœud caché dans la couche cachée est $y_j = f(\sum_i w_{ij} x_i - \theta_j)$, dans laquelle $x_i$ est une entrée du nœud d'entrée de la couche d'entrée, $w_{ji}$ et $\theta_j$ sont respectivement un poids de connexion et un seuil entre chaque nœud caché et chaque nœud d'entrée, i est un indice du nœud d'entrée et j est un indice du nœud caché,

une sortie de chaque nœud de sortie dans la couche de sortie est $O_k = f(\sum_j w_{kj} y_j - \theta_k)$, dans laquelle $w_{kj}$ et $\theta_k$ sont respectivement un poids de connexion et un seuil entre chaque nœud de sortie et chaque nœud caché, et k est un indice du nœud de sortie.

4. Méthode d'avertissement précoce de défaut selon la revendication 3, dans laquelle la fonction d'activation du réseau neural BP est une fonction sigmoïde.

5. Méthode d'avertissement précoce de défaut selon la revendication 3, dans laquelle une erreur entre la valeur de sortie $O_k$ et une valeur de sortie attendue $t_k$ du nœud de sortie de la couche de sortie est

$$E = \frac{1}{2}\sum_k (t_k - O_k)$$

, une fonction de correction de poids dans un transfert inverse est

$$\Delta_{W_{kj}} = -\eta \frac{\partial E}{\partial W_{kj}}, \Delta_{W_{ji}} = -\eta \frac{\partial E}{\partial W_{ji}}$$

, et une fonction de correction de seuil est

$$\Delta \theta_k = -\eta \frac{\partial E}{\partial \theta_k}, \Delta \theta_j = -\eta \frac{\partial E}{\partial \theta_j}$$

, dans laquelle $\eta$ est comprise entre 0,01 ~ 0,8.

6. Méthode d'avertissement précoce de défaut selon la revendication **5,** dans laquelle la valeur de sortie attendue comprend un numéro de défaut indiquant l'état de défaut.

7. Méthode d'avertissement précoce de défaut selon la revendication 1, dans laquelle le type du défaut comprend un ou plusieurs des éléments suivants : défaut de la bague intérieure de roulement, défaut de la bague extérieure de roulement, défaut de la bille de roulement, défaut de la cage de roulement, défaut **d'équilibrage** dynamique du ventilateur, défaut de perte de phase du ventilateur, défaut de court-circuit entre les spires du ventilateur, défaut de déséquilibre de phase du ventilateur, défaut de mise à la terre du ventilateur, défaut de surtension du ventilateur, défaut de surchauffe du condensateur, défaut de perte de capacité, défaut de surchauffe de l'IGBT, défaut de surintensité de l'IGBT, défaut de colmatage du filtre, défaut de la pompe à eau, défaut de l'échangeur thermique, défaut de la plaque de refroidissement par eau, défaut de surchauffe du transformateur et défaut **d'isolement** du transformateur.

8. Méthode d'avertissement précoce de défaut selon la revendication **1,** dans laquelle la caractéristique de défaut correspondant au paramètre de caractéristique de défaut comprend un ou plusieurs des éléments suivants : caractéristique de valeur totale, caractéristique de spectre et caractéristique d'enveloppe concernant la vibration du ventilateur, facteur de puissance, coefficient de déséquilibre, courant de séquence négatif, courant homopolaire, caractéristique de spectre, caractéristique d'enveloppe et caractéristique d'énergie concernant le courant du ventilateur, valeur effective de température et gradient de changement de température concernant la température du transformateur, caractéristique de domaine de valeur effective de courant et de temps de courant concernant le courant du module, caractéristique harmonique de la tension intermédiaire du convertisseur, valeur effective de température et gradient de changement de température de la température de l'IGBT, caractéristique de valeur totale et caractéristique de spectre du courant du condensateur, valeur effective de température et gradient de changement de température de la température de l'eau à l'entrée et à la sortie du convertisseur, valeur effective de la pression de l'eau à l'entrée et à la sortie du convertisseur, et valeur effective de température de la température de l'air à l'entrée et à la sortie d'un filtre.

9. Méthode d'avertissement précoce de défaut selon la revendication 1, comprenant en outre :

l'acquisition de paramètres de performance mesurés de la pluralité de composants fonctionnels du convertisseur (304) ;
le calcul des paramètres de caractéristiques de défaut sur la base des paramètres de performance mesurés (305) ; et
la détermination du défaut du convertisseur sur la base des paramètres de caractéristiques de défaut et du modèle d'avertissement précoce de défaut (306).

10. Méthode d'avertissement précoce de défaut selon la revendication 1, dans laquelle l'ensemble de paramètres de performance correspondant à chaque défaut est collecté dans différentes conditions de fonctionnement du convertisseur, et les conditions de fonctionnement comprennent l'environnement de fonctionnement et le kilométrage d'une locomotive où se trouve le convertisseur.

11. Dispositif d'avertissement précoce de défaut pour un convertisseur basé sur la fusion de multiples informations, comprenant :

une mémoire ; et
un processeur, configuré pour réaliser la méthode selon l'une quelconque des revendications 1 à 10.

12. Support lisible par ordinateur, stockant une instruction exécutable par ordinateur, dans lequel lorsque l'instruction exécutable par ordinateur est exécutée par un processeur, la méthode selon l'une quelconque des revendications 1 à 10 est mise en œuvre.

101

Establishing a performance parameter database of the converter

102

Performing feature extraction on the performance parameter set of the performance parameter database to obtain a fault feature parameter database

103

Performing neural network modeling, based on at least one fault and at least one fault feature parameter group corresponding to each of the fault in the fault feature parameter database, to obtain a fault early warning model representing a mapping relationship between the fault and the fault feature parameters

# Fig. 1

Fig. 2

301

Establishing a performance parameter database of the converter

302

Performing feature extraction on the performance parameter set of the performance parameter database to obtain a fault feature parameter database

303

Performing neural network modeling, based on at least one fault and at least one fault feature parameter group corresponding to each of the fault in the fault feature parameter database, to obtain a fault early warning model representing a mapping relationship between the fault and the fault feature parameters

304

Acquiring measured performance parameters of the plurality of functional components of the converter

305

Calculating the fault feature parameters based on the measured performance parameters

306

Determining the fault of the converter based on the fault feature parameters and the fault early warning model

Fig. 3

401

Establishing a performance parameter database of the converter

402

Performing feature extraction on the performance parameter of each functional component in the performance parameter database to obtain a plurality of groups of performance feature parameters of each functional component

403

Calibrating the plurality of groups of performance feature parameters of each functional component, based on a performance feature threshold corresponding to a different performance of each functional component, to determine a key performance index value corresponding to each group of the performance feature parameters

404

Performing neural network modeling, based on a plurality of groups of performance feature parameters and corresponding key performance index values of each functional component, to obtain a performance evaluation model representing a mapping relationship between the key performance index values of each functional component and the performance feature parameters

Fig. 4

$(w_{ji}, \quad \theta_j)$

$(w_{kj}, \quad \theta_k)$

Fan vibration

Vibration intensity

Spectrum feature

Envelope feature

Fan current

Power factor

Unbalance coefficient

Negative sequence current

Fan voltage

Zero sequence current

1

2

n

Normalized evaluation index of fan state

## Fig. 5

$(w_{ji}, \quad \theta_j)$

$(w_{kj}, \quad \theta_k)$

Module current

Current effective value

Current time domain feature

IGBT temperature

Temperature effective value

1

2

n

Normalized evaluation index of IGBT state

## Fig. 6

$(w_{ji}, \quad \theta_j) \quad (w_{kj}, \quad \theta_k)$

| Capacitor temperature |
| Capacitor current |

| Temperature effective value |
| Capacitance value |
| Capacitor ESR value |

1

2

○
○
○

n

| Normalized evaluation index of capacitor state |

Fig. 7

$(w_{ji}, \quad \theta_j) \quad (w_{kj}, \quad \theta_k)$

| Contactor coil voltage |
| Contactor coil current |

| Contactor coil resistance |
| Contactor breaking time |

1

2

○
○
○

n

| Normalized evaluation index of contactor state |

Fig. 8

Fig. 9

Fig. 10

Fig. 11

Fig. 12

Fig. 13

Fig. 14

Fig. 15

Fig. 16

**EP 4 063 875 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 109116150